# EUROPÄISCHE PATENTSCHRIFT

(11) **EP 1 835 547 B1**
(45) Veröffentlichungstag und Bekanntmachung des Hinweises auf die Patenterteilung: **24.08.2011**
(21) Anmeldenummer: 04821428.2
(22) Anmeldetag: 01.11.2004
(51) Int. Cl.: H01L 31/052, F24J 2/08

(54) **FOTOVOLTAISCHES MODUL**
PHOTOVOLTAIC MODULE
MODULE PHOTOVOLTAIQUE

(30) Priorität: 01.11.2004 RU 2004131615
(43) Veröffentlichungstag der Anmeldung: 19.09.2007
(73) Patentinhaber: Technoexan Ltd., Sankt Petersburg 194021 (RU)
(72) Erfinder: Alferov, Zhores Ivanovich, St. Petersburg 197046 (RU); Andreev, Vyacheslav Mikhaylovich, St. Petersburg 195256 (RU); Zazimko, Vadim Nikolaevich, St. Petersburg 197343 (RU); Ionova, Evgeniya Aleksandrovna, St Petersburg (RU); Lovygin, Igor Vladimirovich, St. Petersburg (RU); Rumantsev, Valeriy Dmitrievich, St. Petersburg 194021 (RU); KHVOSTIKOV, Vladimir Petrovich, 195220 St. Petersburg, (RU); Chalov, Alesksey Evgenevich, St. Petersburg (RU); Shavarts, Maksim Sinovevich, St. Petersburg (RU)
(74) Vertreter: Jeck, Anton
(86) Internationale Anmeldenummer: PCT/RU2004/000429
(87) Internationale Veröffentlichungsnummer: WO 2006/049524

(56) Entgegenhaltungen:
- EP-A- 0 560 107
- DE-A1- 2 924 510
- JP-A- 7 260 261
- JP-A- 58 048 477
- RU-C1- 2 194 927
- US-A- 3 985 116
- US-A- 4 830 678
- US-A- 5 091 018
- US-A- 5 123 968
- US-A1- 2003 075 212
- US-A1- 2003 201 007
- US-A1- 2004 194 820
- US-B1- 6 384 320
- RUMYANTSEV V D ET AL: 'Progress in development of all-glass terrestrial concentrator modules based on composite fresnel lenses and III-V solar cells.' CONFERENCE RECORD ON 28TH IEEE PHOTOVOLTAIC SPECIALIST CONFERENCE-2000. 15 September 2000 - 22 September 2000, Seiten 1169 - 1170, XP008111311

## Beschreibung

Die Erfindung betrifft das Gebiet der Solarenergie, insbesondere fotovoltaische Module. Am besten kann die vorliegende Erfindung in Land-Solarenergieanlagen mit Strahlungskonzentratoren, die für die Systeme der unabhängigen Energieversorgung in verschiedenen klimatischen Zonen bestimmt sind, verwendet werden.

Es ist bekannt, dass die Anwendung der Strahlungskonzentratoren vorbehaltlich der Abstimmung ihrer Parameter mit den Parametern der Solarzellen nicht nur ermöglicht, die Energieeffektivität der fotovoltaischen Module zu erhöhen, sondern auch ihre energiewirtschaftlichen Kennwerte durch Verminderung des Verbrauchs von kostspieligen Halbleitermaterialien zu verbessern. Die Konstruktion der fotovoltaischen Module mit den Sonnenstrahlungskonzentratoren soll ihr langfristiges, wirksames Funktionieren unter realen Betriebsbedingungen bei einem möglichst niedrigen Wert der erzeugten, elektrischen Leistung sicherstellen. Unter Berücksichtigung, dass der Anwendungsbereich von fotovoltaischen Modulen natürliche Umweltbedingungen sind, soll der Schutz des optischen Systems, des Halbleiterelements der Stromableiterkontakte gegen Einwirkungen von Temperatur- und Druckänderungen, Ultraviolettstrahlung der Sonne, hoher Feuchtigkeit, Wind, Staub, Hagel usw. gewährleistet werden. Außerdem wird bei der Absorption der konzentrierten Strahlung ein Teil davon für die Erwärmung des Elements verbraucht; infolgedessen entsteht die Notwendigkeit, die Wärme von der Halbleiterstruktur wirksam abzuleiten, da die überflüssige Erwärmung die Umwandlungseigenschaften des Elements, dessen Lebensdauer und die Ausgangscharakteristik des fotovoltaischen Moduls beeinträchtigt.

Aus dem Buch von B. M Andreev et al. "Fotovoltaische Umwandlung der konzentrierten Sonnenstrahlung", JI., "Wissenschaft", Leningrader Abteilung, 1989, S. 302-303, ist ein fotovoltaisches Modul mit Sonnenstrahlungskonzentratoren bekannt, die als Linsen ausgebildet sind.

Das Modul enthält acht bzw. sechzehn Fresnel-Linsen und eine entsprechende Menge an Solarzellen, die den Linsen gegenüber auf einem Aluminiumblatt angeordnet sind, das gleichzeitig die Rolle einer Unterlage für Solarzellen, eines Heizkörpers und eines Metallgehäuses übernimmt. Zur Elektroisolierung der Solarzellen auf dem Gehäuse werden Platten aus hochohmigem Silizium verwendet, die über eine hohe Wärmeleitfähigkeit verfügen. Die Fresnel-Linsen werden aus einem organischen Glas im Pressverfahren hergestellt. Zum Schutz vor atmosphärischen Einwirkungen werden die Linsen durch ein Blatt aus durchsichtiger Folie abgedeckt. Das Modul übertrifft nach seinen technisch-wirtschaftlichen Kennwerten die der bekannten Siliziummodule ohne Konzentratoren, doch ist die mit ihm erzeugte Energie sehr niedrig.

Das am nächsten kommende Analogon zur vorliegenden Erfindung ist ein fotovoltaisches Modul mit Sonnenstrahlungskonzentratoren, das in den Unterlagen der internationalen Konferenz "CONFERENCE RECORD OF THE TWENTY-EIGHTH IEEE PHOTOVOLTAIC SPECIALISTS CONFERENCE-2000", Ankorage, Alaska, USA, 2000, S. 1169-1172, ausführlich betrachtet wurde.

Dieses Modul enthält Seitenwände aus Silikatgas, auf deren obere Kanten eine Fronttafel aus Silikatglas mit Fresnel-Linsen und auf deren untere Kanten eine Rücktafel aus Silikatglas mit Solarzellen und einer wärmeabführenden Basis befestigt ist. Die Fresnel-Linsen sind aus Silikon hergestellt, weisen eine quadratische Form auf und sind dicht nebeneinander angebracht und mit der Innenfläche des Glases fest verbunden, das eine Schutz- und Trägerfunktion erfüllt. Jeder Fresnel-Linse ist eine eigene Solarzelle zugeordnet, die auf einer wärmeabführenden Metallbasis befestigt ist. Die wärmeabführenden Metallbasen werden auf der Vorderglasseite der Rücktafel so angeordnet, dass die lichtaufnehmende Fläche der Solarzelle im Brennpunktfleck der entsprechenden Fresnel-Linse liegt.

Die wärmeabführende Basis bildet auch einen der elektrischen Kontakte der Solarzelle. Der zweite Kontakt wird durch eine obere Metallschicht eines kaschierten Hartglasgewebes gebildet und auf der wärmeabführenden Metallbasis befestigt, der ein Drahtkontakt mit der Befestigung seines anderen Ende an einem Kontaktnetz der Solarzelle zugeführt ist. Die Umschaltung der Solarzellen wird durch Kontakte verwirklicht, die an der Metallbasis an die obere Metallschicht des Hartglasgewebes angeschlossen sind.

Durch seitliche Glaswände des Moduls wird die Parallelität der Fronttafel und der Rücktafel sowie deren gegenseitige Anordnung unter Berücksichtigung der Sicherung einer genauen Fokussierung gewährleistet. Die Befestigung der Wände untereinander und an die Tafeln wird durch Abdichtungskleber verwirklicht, wodurch die Abkapselung des inneren Modulraums von der umgebenden Atmosphäre gewährleistet und der Schutz aller Elemente des fotovoltaischen Moduls vor äußeren Faktoren sichergestellt wird.

Beim Betrieb des Moduls konzentrieren die zu den Sonnenstrahlen senkrecht ausgerichteten Fresnel-Linsen das Sonnenlicht und bündeln es auf den Lichtaufnahmeflächen der Solarzellen. Die Solarzellen wandeln die Quantenenergie des Lichts in elektrische Energie um, wobei sie eine Potentialdifferenz an ihren Kontakten erzeugen. Die vom Modul erzeugte Elektroenergie wird nach außen dem Nutzer oder einem Energiespeicher zugeführt. Die Wärme, die von den Solarzellen abgeführt wird, wird auf die wärmeabführenden Metallbasen verteilt, auf das Glas der Rücktafel übertragen und dann in die Umwelt abgeführt. Das vorliegende Modul übertrifft hinsichtlich seiner Kennwerte alle anderen, bekannten, fotovoltaischen Module mit Konzentratoren einschließlich des oben beschriebenen Analogons. Es hat jedoch eine ungenügend hohe Größe des Konzentrationskoeffizienten und der Breite der Fehlorientierungscharakteristik des Moduls, wodurch die Energieleistung des Moduls gemindert wird.

Durch RUMYANTSEV V D ET AL: 'Progress in development of all-glass terrestrial concentrator models based on composite fresnel lenses and III-V solar cells.' CONFERENCE RECORD ON 28TH IEEE PHOTOVOLTAIC SPECIALIST CONFERENCE-2000, 15. September 2000 - 22. September 2000, S. 1169-1170, ist ein fotovoltaisches Modul bekannt, mit Seitenwänden, einer Fronttafel aus Silikatglas mit Fresnel-Linsen auf deren rückwärtiger Seite und mit einer Rücktafel aus Silikatglas mit Solarzellen und wärmeabführenden Basen bzw. wärmeabführenden Mitteln auf deren Frontseite.

Durch US 5,091,018 ist ein fotovoltaisches Modul bekannt, mit Seitenwänden, einer Fronttafel mit Fresnel-Linsen und mit einer Rücktafel mit Solarzellen. Bei den Solarzellen handelt es sich jeweils um ein Tandem-Fotozellenmodul mit zwei in Lichteinfallsrichtung nacheinander angeordneten Fotozellen bekannt. Eine obere Fotozelle ist als GaAs-Zelle ausgebildet, eine darunter liegende, unter der oberen Fotozelle angeordnete, so genannte Booster-Zelle ist als GaSb-Zelle ausgebildet. Mittels eines Klebemittels Durch US 2003/0075212 A1 ist ein fotovoltaisches Modul bekannt, mit Seitenwänden, einer Fronttafel mit Fresnel-Linsen und mit einer Rücktafel mit Solarzellen. Zwischen der Fronttafel und der Rücktafel sind Parabolreflektoren auf einer Achse mit den entsprechenden Fresnel-Linsen und den Solarzellen angeordnet. Die Fresnel-Linsen bilden erste optische Konzentratoren und die Parabolreflektoren zweite optische Konzentratoren. Am Boden jedes Parabolreflektors ist jeweils ein dritter optischer Konzentrator in Form einer Glaslinse mit konvexer Oberseite und konkaver Unterseite angeordnet. In einer in der durch die Böden der Parabolreflektoren gebildeten Ebene angeordneten, parallel zur Rücktafel verlaufenden opaken Zwischenwand sind Durchbrüche angeordnet, in denen die dritten optischen Konzentratoren aufgenommen sind. Zwischen der Rücktafel und einer parallel zur Rücktafel verlaufenden, opaken Zwischenwand befindet sich ein offener Raum, durch den ein Kühlmittel strömt.

Die vorliegende Erfindung hat zur Aufgabe, ein fotovoltaisches Modul mit verbesserten Leistungsmerkmalen zu entwickeln.

### Zusammenfassung der Erfindung

Die gestellte Aufgabe wird gelöst, indem bei einem fotovoltaischen Modul mit Seitenwänden, einer Fronttafel aus Silikatglas mit Fresnel-Linsen auf deren rückwärtigen Seite und mit einer Rücktafel mit Solarzellen auf deren Frontseite und einem wärmeabführenden Mittel, zwischen den genannten Tafeln eine zusätzliche Zwischentafel aus Silikatglas angeordnet ist. Die Zwischentafel ist von der Oberfläche der Solarzellen abgetrennt räumlich beabstandet angeordnet. Auf der Zwischentafel sind flachkonvexe Linsen auf einer Achse mit den entsprechenden Fresnel-Linsen und den Solarzellen angebracht. Zwischen Rücktafel und Zwischentafel ist wenigstens ein dicht verschlossener, Luft enthaltender Raum vorhanden.

Bei einer ersten Ausführung des fotovoltaischen Moduls, das Seitenwände, eine Fronttafel aus Silikatglas mit Fresnel-Linsen auf der rückwärtigen Seite und eine

Rücktafel mit Solarzellen und wärmeabführenden Basen auf deren Frontseite umfasst, sind die wärmeabführenden Basen als Schalen mit einem Flachboden ausgebildet, durch deren zentrale, längslaufende Linien der Oberflächen optische Achsen der entsprechenden Fresnel-Linsen laufen; diese Schalen bilden eine Rücktafel, zwischen der und der Fronttafel eine zusätzliche Tafel aus Silikatglas angeordnet ist, auf deren rückwärtigen Seite flachkonvexe Linsen auf einer Achse mit den entsprechenden Fresnel-Linsen angebracht sind, wobei die Schalen durch ihre Oberteile mit der rückwärtigen Oberfläche der Zwischentafel dicht verbunden sind und der Abstand von der Zwischentafel bis zu den rückwärtigen Oberflächen der flachen Schalenböden größer als die Summe der Stärken der Solarzelle und der flachkonvexen Linse, aber kleiner als die Brennweite der flachkonvexen Linsen ist.

Bei einer zweiten Ausführung des fotovoltaischen Moduls, das Seitenwände, eine Fronttafel aus Silikatglas mit Fresnel-Linsen auf der rückwärtigen Seite und eine

Rücktafel mit Solarzellen und wärmeabführenden Basen auf deren Frontseite umfasst, sind die wärmeabführenden Basen als Schalen mit einem Flachboden ausgebildet, durch deren zentrale, längslaufende Linien der Oberflächen optische Achsen der entsprechenden Fresnel-Linsen laufen, die eine Zwischentafel ausbilden, zwischen der und der Fronttafel eine zusätzliche Zwischentafel aus Silikatglas angeordnet ist, auf deren Frontseite die flachkonvexen Linsen auf einer Achse mit den entsprechenden Fresnel-Linsen angebracht sind, wobei die Schalen durch ihre Oberteile mit der rückwärtigen Oberfläche der Zwischentafel dicht verbunden sind und der Abstand von der Zwischentafel bis zu den Oberflächen der flachen Schalenböden größer als die Stärke der Solarzelle, aber kleiner als die Differenz der Brennweiten der flachkonvexen Linsen und die Stärke der Zwischentafel ist.

Die Verwendung eines zusätzlichen Sonnenstrahlungskonzentrators ermöglicht, den Konzentrationsfaktor maximal zu vergrößern und die Fehlorientierung des Moduls breiter zu machen (die Abweichung der Lage des fotovoltaischen Moduls von der Senkrechten der Sonnenstrahlen) oder energiewirtschaftliche Kennwerte des Moduls durch Verminderung des Verbrauchs von Halbleitermaterialien in Solarzellen zu verbessern. Eine räumliche Abtrennung des zusätzlichen Konzentrators von der Oberfläche der Solarzelle ermöglicht auch, die Dichte der dadurch laufenden Sonnenstrahlung zu verringern und somit die Strahlungs- und Temperaturbelastung des zusätzlichen Konzentrators zu verringern, wodurch die Betriebsdaten des fotovoltaischen Moduls verbessert werden.

Ebenso neu für alle Ausführungen der Erfindung ist, dass in den seitlichen, gegenüberliegenden Wänden des fotovoltaischen Moduls unmittelbar über der zusätzlichen Zwischentafel und unter der Fronttafel Öffnungen zur Verbindung mit der Umwelt des inneren Modulraums zwischen diesen Tafeln gebildet sind.

Dank dieser Lösung bleibt nur der Raum zwischen der Rücktafel und der dieser nahe liegenden Zwischentafel zum Schutz der Solarzellen vor Umwelteinwirkungen dicht. In diesem Raum ist eine kleine Luftmenge vorhanden, und eine Änderung des inneren Drucks verursacht praktisch nicht die Entstehung von mechanischen Spannungen im Modulaufbau. Der Raum zwischen der Fronttafel und der zusätzlichen Zwischentafel steht mit der Umwelt in Verbindung. Die Verbindung dieses Raumes mit der Umwelt, in dem die Silikonkonzentratoren angeordnet sind, die ihre Eigenschaften unter Einwirkung der Feuchtigkeit nicht ändern, schließt das Entstehen einer Druckdifferenz zwischen dem inneren Modulraum und der Atmosphäre aus; somit entstehen keine starken, mechanischen Spannungen im Aufbau wie bei dem der Erfindung am nächsten stehenden Analogon.

Nachfolgend wird das Wesen der Ausführungen gemäß der Erfindung durch eine ausführliche Beschreibung mit dem Verweis auf die beigefügten Zeichnungen ausführlich erläutert.

### Kurzfassung der Zeichnungen

In den nachfolgenden Figuren ist Folgendes gezeigt:

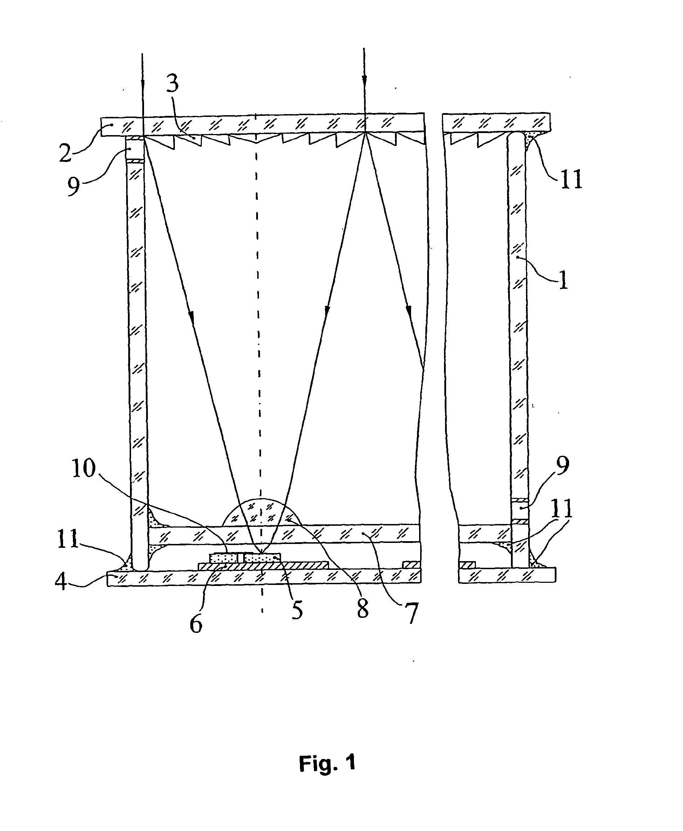

- Fig. 1: ein Querschnitt durch eine schematische Teilansicht eines ersten Ausführungsbeispiels,
- Fig. 2: ein Querschnitt durch eine schematische Teilansicht eines zwei- ten Ausführungsbeispiels,
- Fig. 3: ein Querschnitt durch eine schematische Teilansicht eines dritten Ausführungsbeispiels,
- Fig. 4: ein Querschnitt durch eine schematische Teilansicht eines vier- ten Ausführungsbeispiels und

- Fig. 5: ein Querschnitt durch eine schematische Teilansicht eines fünften Ausführungsbeispiels.

### Ausführliche Beschreibung der Ausführungsbeispiele

Nach dem ersten Ausführungsbeispiel enthält das fotovoltaische Modul Seitenwände 1 aus Silikatglas, auf deren obere Kanten eine Fronttafel 2 aus Silikatglas mit Fresnel-Linsen 3 und auf deren untere Kanten eine Rücktafel 4 aus Silikatglas mit Solarzellen 5 und wärmeabführende Basen 6 befestigt sind. Die Fresnel-Linsen 3 sind aus Silikon hergestellt, weisen eine quadratische Form auf, sind dicht aneinander angeordnet und sind mit der Innenoberfläche des Glases, das eine Schutz- und Trägerfunktion erfüllt, fest verbunden. Jeder Fresnel-Linse 3 ist eine Solarzelle 5 zugeordnet, die auf einer wärmeabführenden Metallbasis 6 befestigt ist. Die wärmeabführenden Basen 6 werden auf der Frontseite des Glases der Rücktafel 4 so angeordnet, dass die lichtaufnehmende Oberfläche der Solarzelle 5 auf der optischen Linie der entsprechenden Fresnel-Linse 3 liegt. Zwischen der Rücktafel 4 und der Fronttafel 2 ist eine zusätzliche Zwischentafel 7 aus Silikatglas angeordnet, auf deren Oberfläche flachkonvexe Silikonlinsen 8 auf einer Achse mit den entsprechenden Fresnel-Linsen 3 und den Solarzellen 5 angebracht sind. Der Abstand von der Zwischentafel 7 bis zu den wärmeabführenden Basen 6 ist größer als die Stärke der Solarzellen 5, aber kleiner als die Größendifferenz der Brennweite der flachkonvexen Linsen 8 und die Stärke der Zwischentafel 7. Für jeden Einzelfall wird dieser Abstand durch die optischen Parameter zweier Sonnenstrahlungskonzentratoren, der Fresnel-Linsen 3 und der flachkonvexen Linsen 8, durch die Bedingungen der optimalen Fokussierung des optischen Systems bestimmt, dass die lichtaufnehmenden Oberflächen der Solarzellen 5 im Brennpunktfleck zweier Konzentratoren, der entsprechenden Fresnel-Linsen 3 und der flachkonvexen Linsen 8, liegen. Die flachkonvexen Linsen 8 werden als Kurzfokuslinsen ausgewählt; deswegen ist der Abstand von der Oberfläche der Zwischentafel 7 bis zur Frontoberfläche der Rücktafel 4 im Vergleich zum Abstand zwischen der Fronttafel 2 und der Zwischentafel 7 gering.

In den gegenüberliegenden Seitenwänden 1 sind unmittelbar über der zusätzlichen Zwischentafel 7 und unter der Fronttafel 2 Durchlasshülsen 9 angeordnet, durch deren Öffnungen der innere Modulraum, der zwischen der Zwischentafel 7 und der Fronttafel 2 eingeschlossen ist, mit der Umwelt verbunden ist. Somit bleibt nur der

Raum zwischen der Rücktafel 4 und der dieser nahe liegenden Zwischentafel 7 zum Schutz der Solarzellen 5 vor Umwelteinwirkungen dicht verschlossen. In diesem Raum ist eine kleine Luftmenge vorhanden, und Änderungen des Innendrucks bei Temperaturänderungen verursachen praktisch kein Entstehen von mechanischen Spannungen im Modulaufbau. Im Raum zwischen der Fronttafel 2 und der Zwischentafel 7 sind die Fresnel-Linsen 3 und die flachkonvexen Linsen 8, die aus Silikon hergestellt sind, angebracht, die ihre Eigenschaften unter der Einwirkung von Feuchtigkeit nicht ändern. Die Verbindung dieses Raumes mit der Umwelt schließt das Entstehen eines Druckgefälles zwischen dem Modulinneren und der Atmosphäre bei Temperaturänderungen vollständig aus. Durch eine derartige Lösung wird somit das Entstehen von mechanischen Spannungen im Modulaufbau im Gegensatz zum Prototyp ausgeschlossen, in dem bei intensiven Temperaturänderungen die mechanischen Spannungen ein kritisches Niveau erreichen können.

Die wärmeabführende Metallbasis 6 bildet auch einen der elektrischen Kontakte der Solarzelle. Der zweite Kontakt wird durch eine obere Metallschicht 10 gebildet, die ein Hartglasgewebe abdeckt, das auf der wärmeabführenden Basis 6 befestigt ist, der ein Drahtkontakt (auf den Figuren nicht gezeigt) zugeführt ist, der mit seinem anderen Ende am Kontaktnetz der Solarzelle 5 angeschlossen ist. Die Umschaltung der Solarzellen 5 wird durch Kontakte vorgenommen, die an der Metallbasis 6 und die obere Metallschicht 10 des Hartglasgewebes angeschlossen sind.

Mit Hilfe der Glasseitenwände 1 des Moduls werden die Parallelität der Fronttafel 2, der Rücktafel 4 und der Zwischentafel 7 sowie deren gegenseitige Anordnung mit Rücksicht auf die Sicherung einer genauen Fokussierung des optischen Systems gewährleistet. Die Befestigung der Seitenwände 1 untereinander und an den Tafeln 2, 4 und 7 wird mittels eines Abdichtungsklebers 11 vorgenommen, wodurch ihre feste Verbindung untereinander und die Dichtheit des inneren Modulraums zwischen der Rücktafel 4 und der Zwischentafel 7 gegenüber der Atmosphäre sichergestellt wird, wobei der Schutz der Solarzellen 5 vor äußeren Faktoren gewährleistet wird.

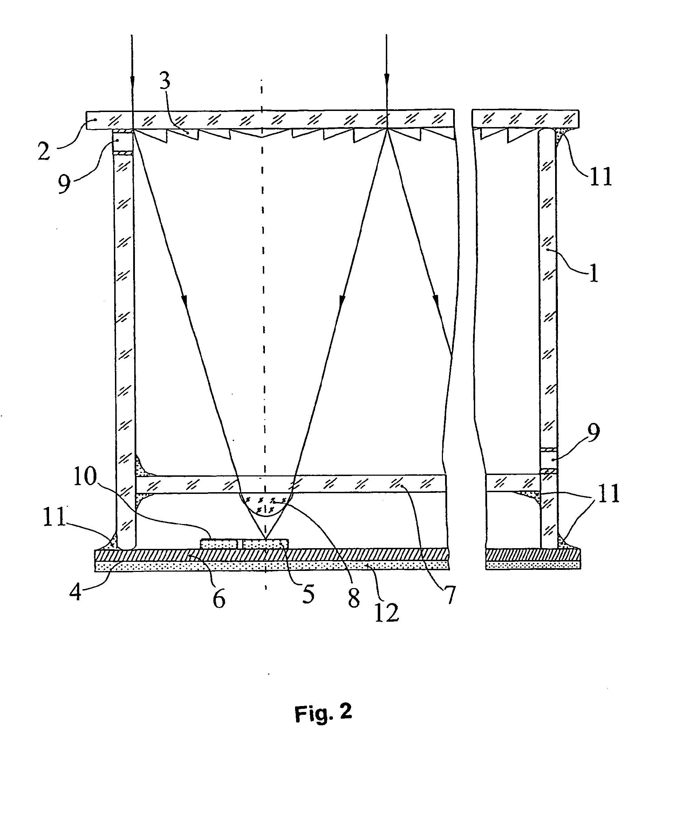

Im zweiten Ausführungsbeispiel (Fig. 2) enthält das fotovoltaische Modul Seitenwände 1 aus Silikatglas, auf deren obere Kanten eine Fronttafel 2 aus Silikatglas mit Fresnel-Linsen 3 und auf deren untere Kanten eine wärmeabführende Metallplatte 6 mit Solarzellen 5 befestigt sind. Somit bildet die Metallplatte 6 eine Rücktafel des fotovoltaischen Moduls.

Die Fresnel-Linsen 3 sind aus Silikon hergestellt und mit der inneren Glasoberfläche der Fronttafel 2 fest verbunden. Jeder Fresnel-Linse 3 ist eine Solarzelle 5 zugeordnet, die auf der wärmeabführenden Metallplatte 6 befestigt ist. Die wärmeabführende Metallplatte 6 wird so angeordnet, dass die lichtaufnehmenden Oberflächen der Photozellen 5 auf den optischen Linien der entsprechenden Fresnel-Linsen 3 liegen.

Zwischen der Metallplatte 6 und der Fronttafel 2 ist eine zusätzliche Zwischentafel 7 aus Silikatglas angeordnet, auf deren rückwärtigen Oberfläche flachkonvexe Linsen 8 aus Silikon auf einer Achse mit den entsprechenden Fresnel-Linsen 3 und der Solarzellen 5 angebracht sind. Der Abstand von der Zwischentafel 7 und der Oberfläche der wärmeabführenden Platte 6 ist größer als die Summe der Stärke der Solarzelle 5 und der flachkonvexen Linse 8, aber kleiner als ihre Brennweite.

In den gegenüberliegenden Seitenwänden 1 sind direkt über der zusätzlichen Zwischentafel 7 und unter der Fronttafel 2 Durchlasshülsen 9 angeordnet, durch deren Öffnungen der Modulinnenraum zwischen der Zwischentafel 7 und der Fronttafel 2 mit der Umwelt verbunden ist. Somit bleibt nur der Raum zwischen den nahe liegenden, rückwärtigen Oberfläche der Zwischentafel 7 und oberen Oberfläche der wärmeabführenden Platte 6 zum Schutz der Solarzellen 5 vor Einwirkungen der Umwelt dicht. Die flachkonvexen Linsen 8 kommen wie auch im ersten Ausführungsbeispiel als Kurzfokuslinsen zum Einsatz; dadurch ist der Abstand zwischen der rückwärtigen Oberfläche der Zwischentafel 7 und der oberen Oberfläche der wärmeabführenden

Metallplatte 6 im Vergleich zum Abstand zwischen der Fronttafel 2 und der Zwischentafel 7 gering. Die wärmeabführende Metallplatte 6 bildet wie im oben beschriebenen Ausführungsbeispiel einen der elektrischen Kontakte der Solarzelle. Der zweite Kontakt wird durch eine obere Metallschicht 10 eines kaschierten Hartglasgewebes gebildet, das auf der wärmeabführenden Metallplatte 6 befestigt ist, dem ein Drahtkontakt (auf den Figuren nicht gezeigt) zugeführt ist, dessen anderes Ende am Kontaktnetz der Solarzelle 5 angeschlossen ist. Die Umschaltung der Solarzellen 5 wird durch Kontakte vorgenommen, die an der Metallplatte 6 und an der oberen Metallschicht 10 des Hartglasgewebes befestigt sind.

Die Befestigung der Seitenwände 1 und der Tafeln 2, 4 und 7 untereinander wird in diesem Ausführungsbeispiel des Moduls wie im ersten Ausführungsbeispiel mittels eines Abdichtungsklebers 11 vorgenommen.

Auf die rückwärtige Seite der wärmeabführenden Metallplatte 6 ist eine strom- und feuchtigkeitsisolierende Schutzschicht 12 aufgetragen. Diese Ausführung des Moduls verfügt im Vergleich zum Prototyp über dieselben Vorteile wie im oben beschriebenen Ausführungsbeispiel. Außerdem sichert diese Ausführungsart eine wirksamere Ableitung der Wärme von den Solarzellen 5 durch die Metallplatte in die Umwelt im Unterschied zum ersten Ausführungsbeispiel, in dem die Ableitung der Wärme durch die Glasplatte der Rücktafel verwirklicht wird.

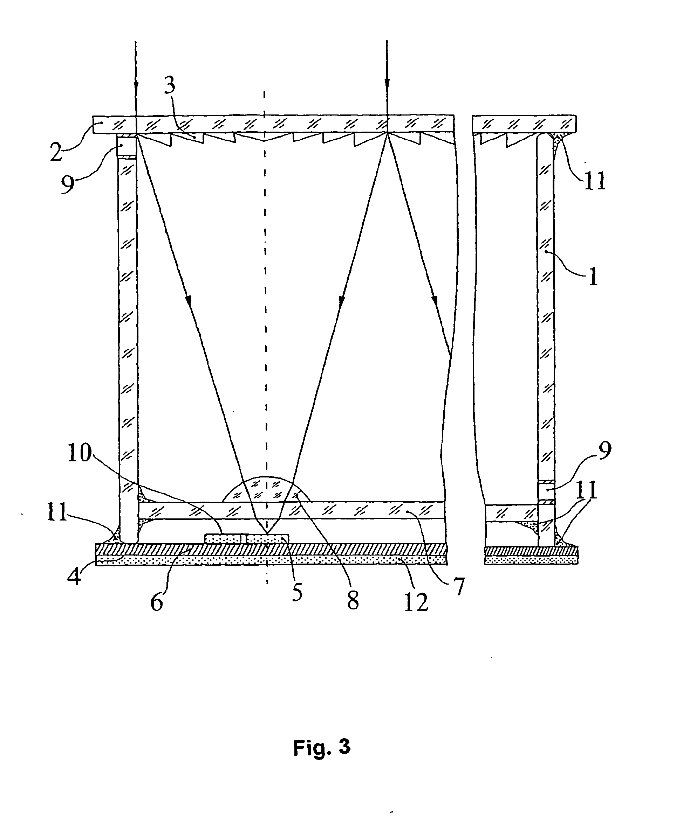

Im dritten Ausführungsbeispiel (Fig. 3) enthält das fotovoltaische Modul Seitenwände 1 aus Silikatglas, auf deren obere Kanten eine Fronttafel 2 aus Silikatglas mit Fresnel-Linsen 3 und auf deren untere Kanten eine wärmeabführende Metallplatte 6 mit Solarzellen 5 befestigt sind. Somit bildet die Metallplatte 6 eine Rücktafel des fotovoltaischen Moduls.

Die Fresnel-Linsen 3 sind aus Silikon hergestellt und mit der Innenglasoberfläche der Fronttafel 2 fest verbunden. Jeder Fresnel-Linse 3 entspricht eine eigene Solarzelle 5, die auf einer Metallplatte 6 befestigt ist. Die Metallplatte 6 wird so angeordnet, dass die Mitte der lichtaufnehmenden Oberflächen der Solarzellen 5 auf den optischen Achsen der entsprechenden Fresnel-Linsen 3 liegt.

Zwischen der wärmeabführenden Metallplatte 6 und der Fronttafel 2 ist eine zusätzliche Zwischentafel 7 aus Silikatglas angeordnet, auf deren Frontoberfläche flachkonvexe Linsen 8 aus Silikon auf einer Achse mit den entsprechenden Fresnel-Linsen 3 und der Solarzellen 5 angeordnet sind. Der Abstand von der Zwischentafel 7 bis zu den wärmeabführenden Metallplatten 6 ist größer als die Stärke der Solarzellen 5 und kleiner als die Größendifferenz des Fokusabstands der flachkonvexen Linsen 8 und der Stärke der Zwischentafel 7.

In den gegenüberliegenden Seitenwänden 1 sind direkt über der zusätzlichen Zwischentafel 7 und unter der Fronttafel 2 Durchlasshülsen 9 angeordnet, durch deren Öffnungen der Modulinnenraum zwischen der Zwischentafel 7 und der Fronttafel 2 mit der Umwelt verbunden ist. Zum Schutz der Solarzellen 5 vor Umwelteinflüssen bleibt somit, wie in den oben beschriebenen Beispielen, nur der Raum zwischen der Rücktafel 4 und der dieser nahe liegenden Zwischentafel 7 dicht. Somit ist das zweite Beispiel des Moduls hinsichtlich dieses Teils der Konstruktion mit den oben beschriebenen Ausführungsbeispielen absolut identisch.

Die wärmeabführende Metallplatte 6 bildet wie im oben beschriebenen Ausführungsbeispiel einen elektrischen Kontakt der Solarzelle. Der zweite Kontakt wird durch eine obere Metallschicht 10 eines kaschierten Hartglasgewebes gebildet, die auf der wärmeabführenden Metallplatte 6 befestigt ist, der ein Drahtkontakt (in der Fig. 3 nicht gezeigt) zugeführt ist, dessen anderes Ende an das Kontaktnetz der Solarzelle 5 angeschlossen ist. Die Umschaltung der Solarzellen 5 wird durch Kontakte vorgenommen, die an der Metallplatte 6 und der oberen Metallschicht 10 des Hartglasgewebes befestigt sind. Auf die rückwärtige Seite der wärmeabführenden Metallplatte 6 ist eine strom- und feuchtigkeitsisolierende Schicht 12 aufgetragen. Das vorliegende Ausführungsbeispiel des Moduls verfügt im Vergleich zum Prototyp über dieselben Vorteile wie das zweite oben beschriebene Ausführungsbeispiel. Außerdem wird im Vergleich zum zweiten Ausführungsbeispiel durch die Anordnung der flachkonvexen Linsen 8 auf der Frontseite der Zwischentafel 7 der Abstand zwischen dieser Tafel und der wärmeabführenden Metallplatte 6 bei denselben optischen Parametern des zusätzlichen Konzentrators (der flachkonvexen Linse 8) kleiner. Dadurch wird die Kompaktheit des Moduls erhöht und das Volumen des dichten Raums zwischen der wärmeabführenden Metallplatte 6 und der rückwärtigen Oberfläche der Zwischentafel 7 verringert, wodurch mechanische Spannungen bei Änderungen der Umwelttemperatur zusätzlich vermindert werden.

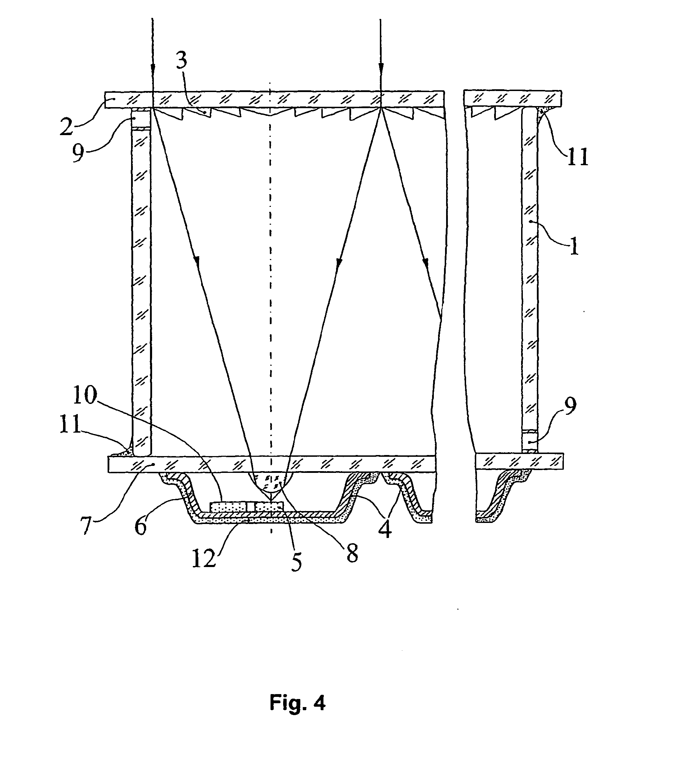

Im vierten Ausführungsbeispiel (Fig. 4) enthält das fotovoltaische Modul Seitenwände 1 aus Silikatglas, auf deren obere Kanten eine Fronttafel 2 aus Silikatglas mit Fresnel-Linsen 3 und auf deren untere Kanten eine Zwischentafel 7 aus Silikatglas befestigt sind. Unter deren rückwärtigen Oberfläche sind wärmeabführende Basen 6 als Schalen mit einem flachen Boden angebracht. Auf den zentralen, längslaufenden Linien der Schalen sind Solarzellen 5 gleichmäßig befestigt. Die Schalen sind mit ihren Abbiegekanten mit Hilfe beliebiger, bekannter Mittel an die rückwärtige Glasoberfläche der Zwischentafel 7 dicht befestigt, wobei die Schalen eine rückwärtige Tafel 4 bilden. Auf der rückwärtigen Oberfläche der Zwischentafel 7 sind flachkonvexe Silikon-Linsen 8 auf einer Achse mit den entsprechenden Fresnel-Linsen 3 angebracht. Der Abstand von der Zwischentafel 7 bis zu den Oberflächen der Flachböden der Schalen ist größer als die Summe der Stärken der Solarzelle und der flachkonvexen Linse und kleiner als deren Brennweite.

In den gegenüberliegenden Seitenwänden 1 sind wie in allen oben beschriebenen Ausführungsbeispielen direkt über der zusätzlichen Zwischentafel 7 und unter der Fronttafel 2 Durchlasshülsen 9 angebracht, durch deren Öffnungen der Modulinnenraum zwischen der Zwischentafel 7 und der Fronttafel 2 mit der Umwelt verbunden ist. In diesem Ausführungsbeispiel bleibt somit nur das summarische Volumen, das durch die Räume zwischen der rückwärtigen Oberfläche der Zwischentafel 7 und der Innenoberfläche der Schalen ausgebildet wird, zur Schutzsicherung der Solarzellen 5 vor Außeneinwirkungen dicht.

Die wärmeabführenden Metallbasen (Schalen 6) bilden wie in allen oben beschriebenen Ausführungsbeispielen einen der elektrischen Kontakte der Solarzelle. Der zweite Kontakt wird durch eine obere Metallschicht 10 eines kaschierten Hartglasgewebes auf der wärmeabführenden Basis 6 gebildet, dem ein Bandkontakt (auf Fig. 4 nicht gezeigt) zugeführt ist, dessen anderes Ende an das Kontaktnetz der Solarzelle 5 angeschlossen ist. In diesem Ausführungsbeispiel werden diese Kontakte für alle Solarzellen in einer Schale zusammengeführt, d.h., dass die Solarzellen 5 parallel angeschlossen werden. Die Umschaltung zwischen den wämeabführenden Basen (Schalen 6) wird durch Metallkontakte (in Fig. 4 nicht gezeigt) vorgenommen, von denen ein Paar an jeder Basis 6 angeschlossen ist.

Die Befestigung der Seitenwände 1 und der Tafeln 2, 4 und 7 untereinander wird in diesem Ausführungsbeispiel wie in allen oben beschriebenen Beispielen vorgenommen. Auf die rückwärtige Seite der Metallschalen wird eine strom- und feuchtigkeitsisolierende Schutzschicht 12 aufgetragen.

Die vorliegende Modulausführung verfügt im Vergleich zum Prototyp über dieselben Vorteile wie die oben beschriebenen Ausführungsbeispiele. Außerdem ergibt sich in diesem Ausführungsbeispiel ein zusätzlicher Vorteil, der damit verbunden ist, dass der Einsatz von wärmeabführenden Basen (Schalen 6) mit der Gruppe geschalteter Solarzellen ermöglicht, die Montage der fotovoltaischen Module zu vereinfachen und bei ihrer Produktion automatisierte, verfahrenstechnische Prozesse einzusetzen, die in der Optoelektronik breit verwendet werden.

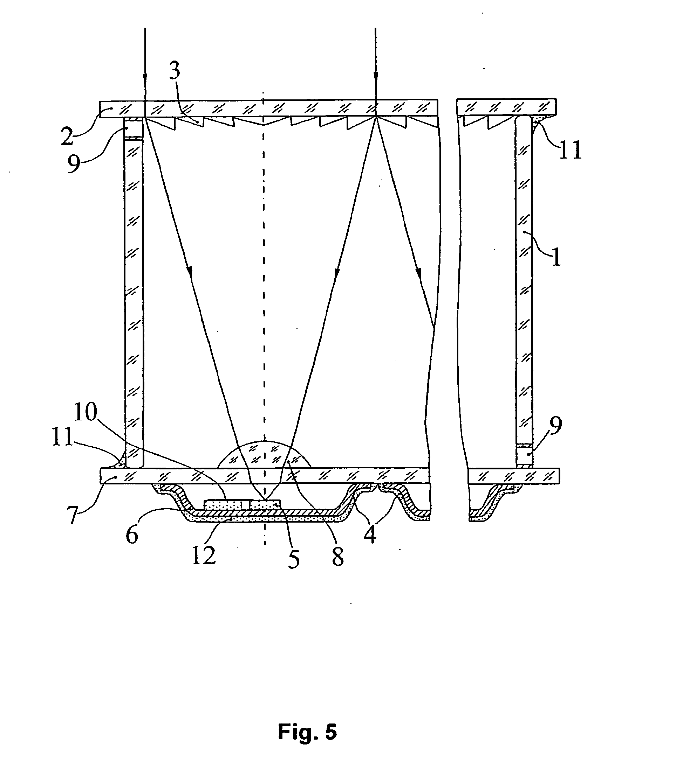

Im fünften Ausführungsbeispiel (Fig. 5) enthält das fotovoltaische Modul Seitenwände 1 aus Silikatglas, auf deren obere Kanten eine Fronttafel 2 aus Silikatglas mit Fresnel-Linsen 3 und auf deren untere Kanten eine Zwischentafel 7 aus Silikatglas befestigt ist. Unter ihrer rückwärtigen Oberfläche sind die wärmeabführenden Basen 6 als Schalen mit einem Flachboden angebracht. Auf den zentralen, längslaufenden Linien der Schalen sind Solarzellen 5 gleichmäßig befestigt. Die Schalen werden durch ihre Abbiegekanten mit Hilfe beliebiger, bekannter Mittel an die rückwärtige Oberfläche der Zwischentafel 7 aus Glas dicht befestigt, wobei sie eine Rücktafel 4 bilden. Auf der Frontoberfläche der Zwischentafel 7 sind flachkon-vexe Silikon-Linsen 8 auf einer Achse mit den entsprechenden Fresnel-Linsen 3 an-geordnet. Der Abstand von der Zwischentafel 7 bis zu den wärmeabführenden Basen 6 ist größer als die Stärke der Solarzelle 5 und kleiner als die Größendifferenz der Brennweite der flachkonvexen Linsen 8 und der Stärke der Zwischentafel 7.

In den gegenüberliegenden Seitenwänden 1 sind wie in allen oben beschriebenen Ausführungsbeispielen direkt über der zusätzlichen Zwischentafel 7 und unter der Fronttafel 2 Durchlasshülsen 9 angeordnet, durch deren Öffnungen der Innenraum zwischen der Zwischentafel 7 und der Fronttafel 2 mit der Umwelt verbunden ist.

Die elektrische Verbindung zwischen den Solarzellen 5 und die Umschaltung der wärmeabführenden Basen (Schalen 6) in diesem Ausführungsbeispiel werden wie im vierten Beispiel vorgenommen.

Die Befestigung der Wände und der Tafeln des Moduls untereinander in diesem Beispiel wird wie in allen oben beschriebenen Ausführungsbeispielen vorgenommen.

Auf die rückwärtige Seite der Metallschalen ist eine strom- und feuchtigkeitsisolierende Schicht 12 aufgetragen.

Dieses Ausführungsbeispiel des Moduls verfügt im Vergleich zum Prototyp über dieselben Vorteile wie die oben beschriebenen Beispiele. In diesem Beispiel verringert sich im Vergleich zu dem vierten Ausführungsbeispiel zusätzlich das summarische Volumen, das durch die Räume zwischen der rückwärtigen Oberfläche der Zwischentafel 7 und durch die innere Oberfläche der Schalen gebildet wird, infolge der Anordnung der flachkonvexen Linsen 8 auf der Frontoberfläche der Zwischentafel 7.

Der Betrieb der Ausführungsbeispiele der vorliegenden Erfindung wird am Betrieb des ersten Ausführungsbeispiels beispielhaft betrachtet.

Beim Modulbetrieb konzentrieren die senkrecht zu den Sonnenstrahlen ausgerichteten Fresnel-Linsen 3 die Sonnenstrahlen und bündeln diese auf die lichtaufnehmenden Oberflächen der Solarzellen 5. Die Solarzellen 5 wandeln die Quantenenergie des Lichts in elektrische Energie um, wobei eine Potentialdifferenz zwischen den Kontakten erzeugt wird. Die vom Modul produzierte Elektroenergie wird einem äußeren Nutzer oder einem Energiespeicher zugeführt. Die von den Solarzellen 5 abgeführte Wärme wird in den wärmeabführenden Metallbasen 6 verteilt, dem Glas der Rücktafel 4 zugeführt und dann in die Umwelt abgegeben.

Die übrigen Ausführungsbeispiele der fotovoltaischen Module funktionieren identisch zum ersten Beispiel. Der Unterschied besteht nur darin, dass die Wärme von den wärmeabführenden Basen (im zweiten und dritten Ausführungsbeispiel sind dies Metallplatten, im vierten und fünften Ausführungsbeispiel sind dies Schalen) in die Umwelt abgegeben wird.

Aus den beschriebenen Ausführungsbeispielen der Erfindung ist für jeden Fachmann in diesem Bereich die Möglichkeit der Realisierung unter der gleichzeitigen Lösung der gestellten Aufgabe ganz offensichtlich. Dabei ist es ebenso offensichtlich, dass bei der Realisierung der Ausführungsbeispiele der Erfindung unbedeutende Veränderungen in der Konstruktion vorgenommen werden können, die jedoch die Grenzen der unten angeführten Ansprüche der Erfindung nicht überschreiten.

### Industrielle Anwendbarkeit

Die Ausführungen von fotovoltaischen Modulen gemäß der vorliegenden Erfindung sind in ihrer Konstruktion einfach. Sie verfügen über hohe Festigkeitsdaten, die einen sicheren und langfristigen Betrieb gewährleisten, sind bei der Herstellung technisch hoch gerecht und verfügen über eine große Energieproduktivität und hohe technischwirtschaftliche Parameter.

## Patentansprüche

1. Fotovoltaisches Modul mit Seitenwänden (1), einer Fronttafel (2) aus Silikatglas mit Fresnel-Linsen (3) auf deren rückwärtigen Seite und mit einer Rücktafel (4) mit Solarzellen (5) auf deren Frontseite und einem wärmeabführenden Mittel (6),
**dadurch gekennzeichnet,**
**dass** zwischen den genannten Tafeln (2, 4) eine zusätzliche Zwischentafel (7) aus Silikatglas angeordnet ist, welche Zwischentafel (7) von der Oberfläche der Solarzellen (5) abgetrennt räumlich beabstandet angeordnet ist, und auf welcher Zwischentafel (7) flachkonvexe Linsen (8) auf einer Achse mit den entsprechenden Fresnel-Linsen (3) und den Solarzellen (5) angebracht sind, wobei zwischen Rücktafel (4) und Zwischentafel (7) wenigstens ein dicht verschlossener, Luft enthaltender Raum vorhanden ist, wobei das wärmeabführende Mittel (6) auf der Frontseite der Rücktafel (4) angeordnete wärmeabführende Basen (6) sind, wobei die wärmeabführenden Basen (6) als Schalen mit einem Flachboden ausgebildet sind, durch deren zentrale längslaufende Linien der Oberflächen die optischen Achsen der entsprechenden Fresnel-Linsen (3) laufen, und welche die Rücktafel (4) ausbilden, und dass die flachkonvexen Linsen (8) auf der rückwärtigen Seite der Zwischentafel (7) angebracht sind, wobei die Schalen durch ihre Oberteile mit der rückwärtigen Oberfläche der Zwischentafel (7) dicht verbunden sind und der Abstand zwischen der Zwischentafel (7) und den Oberflächen der flachen Schalenböden größer als die Summe der Stärken der Solarzelle (5) und der flachkonvexen Linse (8) und kleiner als deren Brennweite ist.

2. Fotovoltaisches Modul mit Seitenwänden (1), einer Fronttafel (2) aus Silikatglas mit Fresnel-Linsen (3) auf deren rückwärtigen Seite und mit einer Rücktafel (4) mit Solarzellen (5) auf deren Frontseite und einem wärmeabführenden Mittel (6),
**dadurch gekennzeichnet,**
**dass** zwischen den genannten Tafeln (2, 4) eine zusätzliche Zwischentafel (7) aus Silikatglas angeordnet ist, welche Zwischentafel (7) von der Oberfläche der Solarzellen (5) abgetrennt räumlich beabstandet angeordnet ist, und auf welcher Zwischentafel (7) flachkonvexe Linsen (8) auf einer Achse mit den entsprechenden Fresnel-Linsen (3) und den Solarzellen (5) ange-bracht sind, wobei zwischen Rücktafel (4) und Zwischentafel (7) wenigstens ein dicht verschlossener, Luft enthaltender Raum vorhanden ist, wobei das wärmeabführende Mittel (6) auf der Frontseite der Rücktafel (4) angeordnete wärmeabführende Basen (6) sind, wobei die wärmeabführenden Basen (6) als Schalen mit einem Flachboden ausgebildet sind, durch deren zentrale längslaufende Linien der Oberflächen die optischen Achsen der entsprechenden Fresnel-Linsen (3) laufen, und welche die Rücktafel (4) ausbilden, und dass die flachkonvexen Linsen (8) auf der Frontseite der Zwischentafel (7) angebracht sind, wobei die Schalen durch ihre Oberteile mit der rückwärtigen Oberfläche der Zwischentafel (7) dicht verbunden sind und der Abstand zwischen der Zwischentafel (7) und den Oberflächen der flachen Schalenböden größer als die Stärke der Solarzelle (5) und kleiner als die Größendifferenz der Brennweite der flachkonvexen Linsen (8) und der Stärke der Zwischentafel (7) ist.

3. Fotovoltaisches Modul nach Anspruch 1 oder 2,
**dadurch gekennzeichnet,**
**dass** in seinen gegenüberliegenden Seitenwänden (1) direkt über der zusätzlichen Zwischenwand (7) und unter der Fronttafel (2) Öffnungen (9) für die Verbindung mit der Umwelt des inneren Modulraums zwischen diesen Tafeln gebildet sind.

## Claims

1. A photovoltaic module, having side walls (1), a front panel (2) of silicate glass with Fresnel lenses (3) on its back side, and a rear panel (4) with solar cells (5) on its front side and with a heat-dissipating means (6),
**characterized in that**
between the aforementioned panels (2, 4), an additional intermediate panel (7) of silicate glass is disposed, which intermediate panel (7) is disposed separately and spatially spaced apart from the surface of the solar cells (5), and on which intermediate panel (7) flat-convex lenses (8) are mounted on an axis with the corresponding Fresnel lenses (3) and the solar cells (5), and between the rear panel (4) and intermediate panel (7) there is at least one tightly closed, chamber containing air, and the heat-dissipating means (6) are heat-dissipating bases (6) disposed on the front side of the rear panel (4), and the heat-dissipating bases (6) are embodied as shells with a flat bottom, through the central longitudinally extending lines of the surfaces of which the optical axes of the corresponding Fresnel lenses (3) extend, and which form the rear panels (4); and that the flat-convex lenses (8) are mounted on the back side of the intermediate panel (7), and the shells are tightly joined by their upper parts to the rear surface of the intermediate panel (7), and the spacing between the intermediate panel (7) and the surfaces of the flat shell bottoms is greater than the sum of the thicknesses of the solar cell (5) and the flat-convex lens (8) and less than the focal length thereof.

2. A photovoltaic module, having side walls (1), a front panel (2) of silicate glass with Fresnel lenses (3) on its back side, and a rear panel (4) with solar cells (5) on its front side and with a heat-dissipating means (6),
**characterized in that**
between the aforementioned panels (2, 4), an additional intermediate panel (7) of silicate glass is disposed, which intermediate panel (7) is disposed separately and spatially spaced apart from the surface of the solar cells (5), and on which intermediate panel (7) flat-convex lenses (8) are mounted on an axis with the corresponding Fresnel lenses (3) and the solar cells (5), and between the rear panel (4) and intermediate panel (7) there is at least one tightly closed, chamber containing air, and the heat-dissipating means (6) are heat-dissipating bases (6) disposed on the front side of the rear panel (4), and the heat-dissipating bases (6) are embodied as shells with a flat bottom, through the central longitudinally extending lines of the surfaces of which the optical axes of the corresponding Fresnel lenses (3) extend, and which form the rear panels (4); and that the flat-convex lenses (8) are mounted on the front side of the intermediate panel (7), and the shells are tightly joined by their upper parts to the rear surface of the intermediate panel (7), and the spacing between the intermediate panel (7) and the surfaces of the flat shell bottoms is greater than the thickness of the solar cell (5) and less than the difference in size of the focal length of the flat-convex lenses (8) and of the thickness of the intermediate panel (7).

3. The photovoltaic module as defined by claim 1 or 2,
**characterized in that**
in its opposed side walls (1), directly above the additional intermediate panel (7) and below the front panel (2), openings (9) for communication with the surroundings of the inner module chamber between these panels are formed.

## Revendications

1. Module photovoltaïque comprenant des parois latérales (1), un panneau frontal (2) en verre de silicate présentant des lentilles de Fresnel (3) sur sa face postérieure, un panneau arrière (4) muni de cellules solaires (5) sur sa face antérieure, et un moyen (6) de dissipation de chaleur,
**caractérisé par le fait**
**qu'**un panneau intercalaire additionnel (7) en verre de silicate est interposé entre les panneaux (2, 4) précités, lequel panneau intercalaire (7) est placé à distance de la surface des cellules solaires (5), dont il est séparé dans l'espace, des lentilles plan-convexes (8) étant implantées sur ledit panneau intercalaire (7), conjointement sur un axe avec les lentilles de Fresnel (3) correspondantes et avec les lentilles solaires (5), au moins un espace confiné hermétiquement, renfermant de l'air, étant présent entre ledit panneau arrière (4) et ledit panneau intercalaire (7), le moyen (6) de dissipation de chaleur se présentant comme des socles (6) dissipateurs de chaleur qui sont disposés sur la face antérieure dudit panneau arrière (4), lesdits socles (6) dissipateurs de chaleur étant réalisés sous la forme de cuvettes à fond aplati, par les lignes médianes longitudinales des surfaces desquelles s'étendent les axes optiques des lentilles de Fresnel (3) correspondantes, et qui forment ledit panneau arrière (4) ; et par le fait que lesdites lentilles plan-convexes (8) sont implantées sur la face postérieure du panneau intercalaire (7), sachant que lesdites cuvettes sont reliées de manière étanche, par leurs parties supérieures, à la surface postérieure dudit panneau intercalaire (7) et que la distance, comprise entre ledit panneau intercalaire (7) et les surfaces des fonds aplatis desdites cuvettes, est plus grande que la somme des épaisseurs de la cellule solaire (5) et de la lentille plan-convexe (8), et plus petite que la distance focale de ces dernières.

2. Module photovoltaïque comprenant des parois latérales (1), un panneau frontal (2) en verre de silicate présentant des lentilles de Fresnel (3) sur sa face postérieure, un panneau arrière (4) muni de cellules solaires (5) sur sa face antérieure, et un moyen (6) de dissipation de chaleur,
**caractérisé par le fait**
**qu'**un panneau intercalaire additionnel (7) en verre de silicate est interposé entre les panneaux (2, 4) précités, lequel panneau intercalaire (7) est placé à distance de la surface des cellules solaires (5), dont il est séparé dans l'espace, des lentilles plan-convexes (8) étant implantées sur ledit panneau intercalaire (7), conjointement sur un axe avec les lentilles de Fresnel (3) correspondantes et avec les lentilles solaires (5), au moins un espace confiné hermétiquement, renfermant de l'air, étant présent entre ledit panneau arrière (4) et ledit panneau intercalaire (7), le moyen (6) de dissipation de chaleur se présentant comme des socles (6) dissipateurs de chaleur qui sont disposés sur la face antérieure dudit panneau arrière (4), lesdits socles (6) dissipateurs de chaleur étant réalisés sous la forme de cuvettes à fond aplati, par les lignes médianes longitudinales des surfaces desquelles s'étendent les axes optiques des lentilles de Fresnel (3) correspondantes, et qui forment ledit panneau arrière (4) ; et par le fait que lesdites lentilles plan-convexes (8) sont implantées sur la face antérieure du panneau intercalaire (7), sachant que lesdites cuvettes sont reliées de manière étanche, par leurs parties supérieures, à la surface postérieure dudit panneau intercalaire (7) et que la distance, comprise entre ledit panneau intercalaire (7) et les surfaces des fonds aplatis desdites cuvettes, est plus grande que l'épaisseur de la cellule solaire (5) et plus petite que la différence entre les cotes de la distance focale desdites lentilles plan-convexes (8), et de l'épaisseur dudit panneau intercalaire (7).

3. Module photovoltaïque selon la revendication 1 ou 2,
**caractérisé par le fait**
**que** des orifices (9) sont pratiqués dans ses parois latérales opposées (1), directement au-dessus du panneau intercalaire additionnel (7) et au-dessous du panneau frontal (2) en vue de relier, à l'espace environnant, l'espace modulaire intérieur situé entre ces panneaux.
